# EUROPEAN PATENT SPECIFICATION

(11) **EP 4 318 618 B1**
(45) Date of publication and mention of the grant of the patent: **10.09.2025**
(21) Application number: 21932866.3
(22) Date of filing: 22.03.2021
(51) Int. Cl.: H10N 60/80, H10N 60/01, H10N 69/00, H01L 21/768, H01L 23/48, H10N 60/12

(54) **SUPERCONDUCTING DEVICE, SUPERCONDUCTING DEVICE MANUFACTURING METHOD, AND LAMINATED BODY**
SUPRALEITENDE VORRICHTUNG, HERSTELLUNGSVERFAHREN FÜR DIE SUPRALEITENDE VORRICHTUNG UND LAMINIERTER KÖRPER
DISPOSITIF SUPRACONDUCTEUR, PROCÉDÉ DE FABRICATION DE DISPOSITIF SUPRACONDUCTEUR ET CORPS STRATIFIÉ

(43) Date of publication of application: 07.02.2024
(73) Proprietor: FUJITSU LIMITED, Kawasaki-shi, Kanagawa 211-8588 (JP)
(72) Inventor: NAKAMURA, Makoto, Kawasaki-shi, Kanagawa 211-8588 (JP)
(74) Representative: Hoffmann Eitle
(86) International application number: PCT/JP2021/011752
(87) International publication number: WO 2022/201253

(56) References cited:
- JP-A- 2019 504 511
- JP-A- 2020 520 090
- JP-A- H0 269 994
- JP-A- H11 177 157
- JP-A- S5 397 798
- US-A1- 2017 373 044
- US-A1- 2018 131 376
- US-B1- 9 836 699

## Description

### FIELD

The disclosed technology relates to a superconducting device, a method of manufacturing a superconducting device, and a laminated body.

### BACKGROUND

The following technology is known as a technology related to a superconducting device having a structural portion exhibiting superconductivity. For example, a semiconductor device is known that includes a base substrate, a carrier substrate, and a buried metallization layer that intermediates the base substrate and the carrier substrate. A method of manufacturing the semiconductor device includes the following processing. A top metallization layer of a first conductive metal material is formed on a top surface of the carrier substrate. Next, unfilled through-substrate-vias are formed in the carrier substrate to the buried metallization layer. Next, an under bump metallization layer of a second conductive metal material is formed on surfaces defining the unfilled through-substrate-vias and a perimeter surrounding the unfilled through-substrate-vias on the carrier substrate, and on the first conductive metal material layer. The under bump metallization layer is coupled to the buried metallization layer and the top metallization layer. The first conductive metal material and the second conductive metal material are different. Next, a sacrificial layer is deposited and patterned to form openings exposing the unfilled through-substrate-vias and the perimeter surrounding the unfilled through-substrate-vias on the carrier substrate and on the top metallization layer. Next, the openings are filled with a third conductive metal material to form a filled through-substrate-via. Next, the sacrificial layer is removed to form a cylindrical shaped solder bump self-aligned to the filled through-substrate-via.

US 9 836 699 B1 relates to a quantum computing apparatus, including a quantum circuit device; and an interposer including a connectorization layer including a plurality of terminals for connecting the quantum computing apparatus to a corresponding plurality of cables and a plurality of signal lines electrically coupled, via electrical contacts, to the plurality of terminals; and at least one intermediate layer between the quantum circuit device and the connectorization layer, the at least one intermediate layer comprising an integrated circuit layer, the at least one intermediate layer being electrically coupled to the signal lines of the interposer.

US 2017/373044 A1 relates to a cryogenic electronic package which includes at least two superconducting and/or conventional metal semiconductor structures. Each of the semiconductor structures includes a substrate and a superconducting trace. Additionally, each of the semiconductor structures includes a passivation layer and one or more under bump metal structures. The cryogenic electronic package also includes one or more superconducting and/or conventional metal interconnect structures disposed between selected ones of the at least two superconducting semiconductor structures.

US 2018/131376 A1 relates to a superconducting device including at least one superconducting element having a first coefficient of thermal expansion. The at least one superconducting element is formed on a dielectric layer having a second coefficient of thermal expansion and the first coefficient of thermal expansion is different from the second coefficient of thermal expansion causing a strain mismatch between the at least one superconducting element and the dielectric layer when the superconducting device is operating in a cryogenic environment.

### SUMMARY

### TECHNICAL PROBLEM

An object of the disclosed technology is to suppress stress associated with temperature change in a superconducting device.

### SOLUTION TO PROBLEM

A superconducting device according to the disclosed technology includes a substrate, a through hole provided in the substrate, and a through electrode provided in the through hole. The through electrode includes a first portion and a second portion provided between the first portion and an inner wall surface of the through hole, in which the second portion is formed of a material that includes a first metal that exhibits superconductivity at a temperature equal to or lower than a predetermined temperature. The superconducting device includes a junction electrode that is an electrode electrically coupled to the through electrode, that has at least a part provided outside the through hole, and that is formed of a material that includes a second metal that exhibits superconductivity at a temperature equal to or lower than a predetermined temperature, and a partition wall that is provided between the through electrode and the junction electrode and that is formed of a material that includes the first metal. A melting point of the first metal is higher than a melting point of the second metal. The invention is defined by the appended claims.

### ADVANTAGEOUS EFFECTS OF INVENTION

According to the disclosed technology, it is possible to suppress stress associated with temperature change in a superconducting device.

### BRIEF DESCRIPTION OF DRAWINGS

FIG. 1 is a cross-sectional view illustrating an example of a configuration of a superconducting device according to an embodiment of the disclosed technology;
FIG. 2 is a view illustrating an example of a configuration of a superconducting qubit element according to the embodiment of the disclosed technology;
FIG. 3A is a cross-sectional view illustrating an example of a method of manufacturing the superconducting device according to the embodiment of the disclosed technology;
FIG. 3B is a cross-sectional view illustrating an example of the method of manufacturing the superconducting device according to the embodiment of the disclosed technology;
FIG. 3C is a cross-sectional view illustrating an example of the method of manufacturing the superconducting device according to the embodiment of the disclosed technology;
FIG. 3D is a cross-sectional view illustrating an example of the method of manufacturing the superconducting device according to the embodiment of the disclosed technology;
FIG. 3E is a cross-sectional view illustrating an example of the method of manufacturing the superconducting device according to the embodiment of the disclosed technology;
FIG. 3F is a cross-sectional view illustrating an example of the method of manufacturing the superconducting device according to the embodiment of the disclosed technology;
FIG. 3G is a cross-sectional view illustrating an example of the method of manufacturing the superconducting device according to the embodiment of the disclosed technology;
FIG. 3H is a cross-sectional view illustrating an example of the method of manufacturing the superconducting device according to the embodiment of the disclosed technology;
FIG. 3I is a cross-sectional view illustrating an example of the method of manufacturing the superconducting device according to the embodiment of the disclosed technology;
FIG. 3J is a cross-sectional view illustrating an example of the method of manufacturing the superconducting device according to the embodiment of the disclosed technology;
FIG. 3K is a cross-sectional view illustrating an example of the method of manufacturing the superconducting device according to the embodiment of the disclosed technology;
FIG. 3L is a cross-sectional view illustrating an example of the method of manufacturing the superconducting device according to the embodiment of the disclosed technology;
FIG. 3M is a cross-sectional view illustrating an example of the method of manufacturing the superconducting device according to the embodiment of the disclosed technology;
FIG. 4A is a cross-sectional view illustrating an example of a method of manufacturing the superconducting device according to the embodiment of the disclosed technology;
FIG. 4B is a cross-sectional view illustrating an example of the method of manufacturing the superconducting device according to the embodiment of the disclosed technology;
FIG. 4C is a cross-sectional view illustrating an example of the method of manufacturing the superconducting device according to the embodiment of the disclosed technology;
FIG. 4D is a cross-sectional view illustrating an example of the method of manufacturing the superconducting device according to the embodiment of the disclosed technology;
FIG. 4E is a cross-sectional view illustrating an example of the method of manufacturing the superconducting device according to the embodiment of the disclosed technology;
FIG. 4F is a cross-sectional view illustrating an example of the method of manufacturing the superconducting device according to the embodiment of the disclosed technology;
FIG. 4G is a cross-sectional view illustrating an example of the method of manufacturing the superconducting device according to the embodiment of the disclosed technology;
FIG. 4H is a cross-sectional view illustrating an example of the method of manufacturing the superconducting device according to the embodiment of the disclosed technology;
FIG. 4I is a cross-sectional view illustrating an example of the method of manufacturing the superconducting device according to the embodiment of the disclosed technology;
FIG. 4J is a cross-sectional view illustrating an example of the method of manufacturing the superconducting device according to the embodiment of the disclosed technology;
FIG. 4K is a cross-sectional view illustrating an example of the method of manufacturing the superconducting device according to the embodiment of the disclosed technology;
FIG. 5 is a cross-sectional view illustrating an example of a configuration of the superconducting device according to the embodiment of the disclosed technology;
FIG. 6 is a cross-sectional view illustrating an example of a configuration of a superconducting device according to an embodiment of the disclosed technology;
FIG. 7 is a cross-sectional view illustrating an example of a configuration of the superconducting device according to the embodiment of the disclosed technology;
FIG. 8 is a cross-sectional view illustrating an example of a configuration of a laminated body according to an embodiment of the disclosed technology;
FIG. 9 is a cross-sectional view illustrating an example of a configuration of the laminated body according to the embodiment of the disclosed technology;
FIG. 10 is a cross-sectional view illustrating an example of a configuration of the laminated body according to the embodiment of the disclosed technology; and
FIG. 11 is a cross-sectional view illustrating an example of a configuration of the laminated body according to the embodiment of the disclosed technology.

### DESCRIPTION OF EMBODIMENTS

A quantum computer is considered to have overwhelming processing capability as compared with a conventional computer by using quantum mechanical phenomena such as superposition and quantum entanglement. As a device for implementing the quantum computer, for example, a superconducting device using a Josephson device including a superconducting material has been proposed. The Josephson device is a switching element using a tunnel effect of a current in a superconducting state. The superconducting device is usually used in a cryogenic environment because superconductivity is exhibited in a cryogenic environment such as several mK.

On the other hand, it is considered that high density mounting becomes possible by laminating superconducting devices on each other or laminating a superconducting device and another device. In the superconducting device, it is considered to use a through electrode as means for implementing three-dimensional mounting. Specifically, a superconducting device including a substrate, a through electrode penetrating the substrate, and a junction electrode electrically coupled to the through electrode is assumed. The superconducting device is laminated on another device via the junction electrode by reflow processing. In the reflow processing, the superconducting device is exposed to a temperature equal to or higher than a melting point of the junction electrode. In a case where the junction electrode includes, for example, Sn, Pb, or an alloy thereof, the melting point of the junction electrode is equal to or higher than 200°C, and a reflow temperature is set to about 300°C. In other words, in the superconducting device, a difference between a temperature at the time of mounting and a temperature at the time of use is equal to or higher than 500°C. Therefore, in the superconducting device used in the cryogenic environment, as compared with a general device used in a normal temperature environment, volume fluctuation associated with expansion and contraction of the through electrode and the junction electrode increases, and there is a high risk that damage such as cracks occurs in these electrodes. In particular, in a structure in which a through electrode and a junction electrode are integrally formed as described in Patent Document 1, deposition of the structure in which the through electrode and the joint electrode are integrated becomes large, so that the volume fluctuation and stress associated with volume fluctuation become more remarkable.

Hereinafter, an example of embodiments of the disclosure will be described with reference to the drawings. Note that, in the respective drawings, the same or equivalent components and portions are given the same reference signs and redundant description will be omitted as appropriate.

### [First Embodiment]

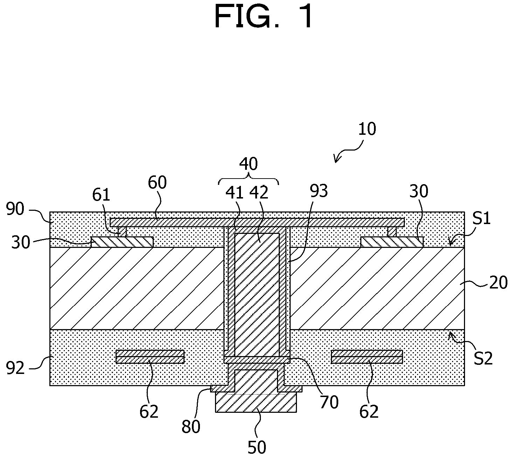

FIG. 1 is a cross-sectional view illustrating an example of a configuration of a superconducting device 10 according to a first embodiment of the disclosed technology. The superconducting device 10 includes a substrate 20, superconducting qubit elements 30, a through electrode 40, and a junction electrode 50.

The substrate 20 includes an insulator or a semiconductor. Use of a semiconductor such as silicon as the substrate 20 facilitates application of an existing semiconductor processing technology.

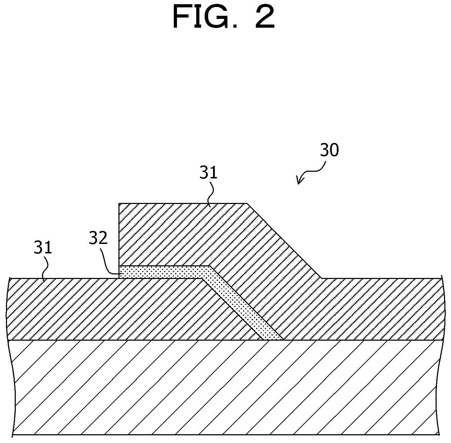

The superconducting qubit elements 30 are provided on a side of a surface S1 of the substrate 20. The superconducting qubit element 30 is an element that forms a coherent two-level system using superconductivity. In the present embodiment, the superconducting qubit element 30 includes a Josephson device illustrated in FIG. 2. The Josephson device includes a pair of superconductors 31 that exhibit superconductivity at a temperature equal to or lower than a predetermined critical temperature, and an ultrathin insulator 32 having a thickness of about several nm sandwiched between the pair of superconductors 31. The superconductor 31 may be, for example, aluminum, and the insulator 32 may be, for example, aluminum oxide. A wiring 60 is coupled to the superconducting qubit elements 30 via vias 61. Each of the vias 61 and the wiring 60 includes a high melting point metal that exhibits superconductivity at a temperature equal to or lower than a predetermined temperature. Details of the high melting point metal will be described later. The surface S1 of the substrate 20 is covered with an insulator layer 90 including an insulator such as SiO₂, and the superconducting qubit elements 30, the vias 61, and the wiring 60 are buried in the insulator layer 90.

The through electrode 40 penetrates the substrate 20. One end of the through electrode 40 is coupled to the wiring 60 provided on the side of the surface S1 of the substrate 20, and the other end is coupled to the junction electrode 50 via a cap film 70 provided on a side of a surface S2 opposite to the surface S1 of the substrate 20. In other words, the through electrode 40 functions as a transmission path for transmitting a qubit output from the superconducting qubit element 30 provided on the side of the surface S1 of the substrate 20 to the junction electrode 50 provided on the side of the surface S2 of the substrate 20.

The through electrode 40 includes an outer portion 41 and an inner portion 42. The outer portion 41 includes a high melting point metal that exhibits superconductivity at a temperature equal to or lower than a predetermined temperature, and surrounds the inner portion 42. The inner portion 42 includes a low melting point metal that exhibits superconductivity at a temperature equal to or lower than a predetermined temperature. In other words, the inside of the through electrode 40 is filled with the low melting point metal that exhibits superconductivity at the temperature equal to or lower than the predetermined temperature. Details of the low melting point metal will be described later. An end portion of the through electrode 40 on the side of the surface S2 of the substrate 20 is closed by the cap film 70. The cap film 70 includes a high melting point metal that exhibits superconductivity at a temperature equal to or lower than a predetermined temperature. The cap film 70 functions as a partition wall separating the through electrode 40 and the junction electrode 50. The low melting point metal constituting the inner portion 42 of the through electrode 40 is completely surrounded (sealed) by the high melting point metal constituting the through electrode 40 and the high melting point metal constituting the cap film 70. An insulating film 93 including an insulator such as SiO₂ is provided between the substrate 20 and the through electrode 40. In other words, the substrate 20 and the through electrode 40 are electrically separated from each other. The surface S2 of the substrate 20 is covered with an insulator layer 92. The cap film 70 is buried in the insulator layer 92, and the end portion of the through electrode 40 on the side of the surface S2 of the substrate 20 reaches the inside of the insulator layer 92.

The junction electrode 50 has a form of a so-called bump, and functions as an external coupling terminal for joining the superconducting device 10 to another device. The junction electrode 50 is provided on the side of the surface S2 of the substrate 20, and is coupled to the through electrode 40 via the cap film 70 and a base film 80. In the present embodiment, the junction electrode 50 is provided immediately below the through electrode 40. The junction electrode 50 includes a low melting point metal that exhibits superconductivity at a temperature equal to or lower than a predetermined temperature. The junction electrode 50 includes a portion buried in the insulator layer 92 and a portion exposed from a surface of the insulator layer 92. The base film 80 is interposed between the junction electrode 50 and the insulator layer 92. The base film 80 functions as a so-called under bump metal, and has a function of suppressing diffusion of the low melting point metal constituting the junction electrode 50 into the insulator layer 92 and a function of enhancing adhesion between the junction electrode 50 and the insulator layer 92. Furthermore, the base film 80 functions as a partition wall separating the through electrode 40 and the junction electrode 50. The base film 80 includes a high melting point metal that exhibits superconductivity at a temperature equal to or lower than a predetermined temperature.

In the insulator layer 92, dummy wirings 62 that are not electrically coupled to the superconducting qubit elements 30 are provided. A potential of the dummy wiring 62 may be, for example, a ground potential or floating. The dummy wiring 62 is provided as needed in order to balance a wiring density on the side of the surface S1 of the substrate 20 and a wiring density on the side of the surface S2 of the substrate 20. In a case where the wiring density on the side of the surface S1 of the substrate 20 and the wiring density on the side of the surface S2 of the substrate 20 are not uniform, warpage occurring in the substrate 20 becomes remarkable. By providing the dummy wiring 62 on the side of the surface S2 of the substrate 20 as appropriate and balancing the wiring densities of both surfaces of the substrate 20, it is possible to suppress the warpage occurring in the substrate 20. Note that a wiring electrically coupled to the superconducting qubit element 30 or a wiring having a specific electrical function may be provided on the side of the surface S2 of the substrate 20. Furthermore, the dummy wiring and the wiring having the specific electrical function may be provided so as to be mixed on the side of the surface S2 of the substrate 20.

As described above, each of the vias 61, the wiring 60, the outer portion 41 of the through electrode 40, the cap film 70, and the base film 80 includes a high melting point metal that exhibits superconductivity at a temperature equal to or lower than a predetermined temperature. The respective high melting point metals constituting the vias 61, the wiring 60, the outer portion 41 of the through electrode 40, the cap film 70, and the base film 80 are preferably the same metals as each other. Furthermore, as described above, each of the inner portion 42 of the through electrode 40 and the junction electrode 50 includes a low melting point metal that exhibits superconductivity at a temperature equal to or lower than a predetermined temperature. The respective low melting point metals constituting the inner portion 42 of the through electrode 40 and the junction electrode 50 are preferably the same metals as each other.

In the present specification, the high melting point metal is a metal having a melting point of equal to or higher than 800°C, and the low melting point metal is a metal having a melting point of equal to or lower than 300°C. As examples of the high melting point metal that exhibits superconductivity at the temperature equal to or lower than the predetermined temperature, Ta, Nb, V, and Mo, alloys including these as main components, nitrides thereof, or the like are exemplified. As examples of the low melting point metal that exhibits superconductivity at the temperature equal to or lower than the predetermined temperature, Sn, Pb, In, and Ga, alloys including these as main components, or the like are exemplified. Note that the high melting point metal is an example of a first metal in the disclosed technology. The low melting point metal is an example of a second metal in the disclosed technology.

The high melting point metal and the low melting point metal that exhibit superconductivity at the temperature equal to or lower than the predetermined temperature preferably have a small difference from a thermal expansion coefficient of the substrate 20. For example, in a case where the substrate 20 is a Si substrate, Mo or Ta is preferably used as the high melting point metal, and Ga or Sn is preferably used as the low melting point metal.

Furthermore, by using Ga (melting point is 29.8°C) or In (melting point is 156.6°C) having a relatively low melting point as the low melting point metal that exhibits superconductivity at the temperature equal to or lower than the predetermined temperature, it is possible to reduce a difference between a temperature at the time of mounting the superconducting device 10 and a temperature at the time of use of the superconducting device 10, and it is possible to suppress volume fluctuation due to temperature fluctuation and stress associated with the volume fluctuation.

Furthermore, metals used as the high melting point metal and the low melting point metal that exhibit superconductivity at the temperature equal to or lower than the predetermined temperature may be selected from a viewpoint of ease of processing. For example, both Ta as the high melting point metal and Sn as the low melting point metal may be patterned by chlorine-based reactive dry etching.

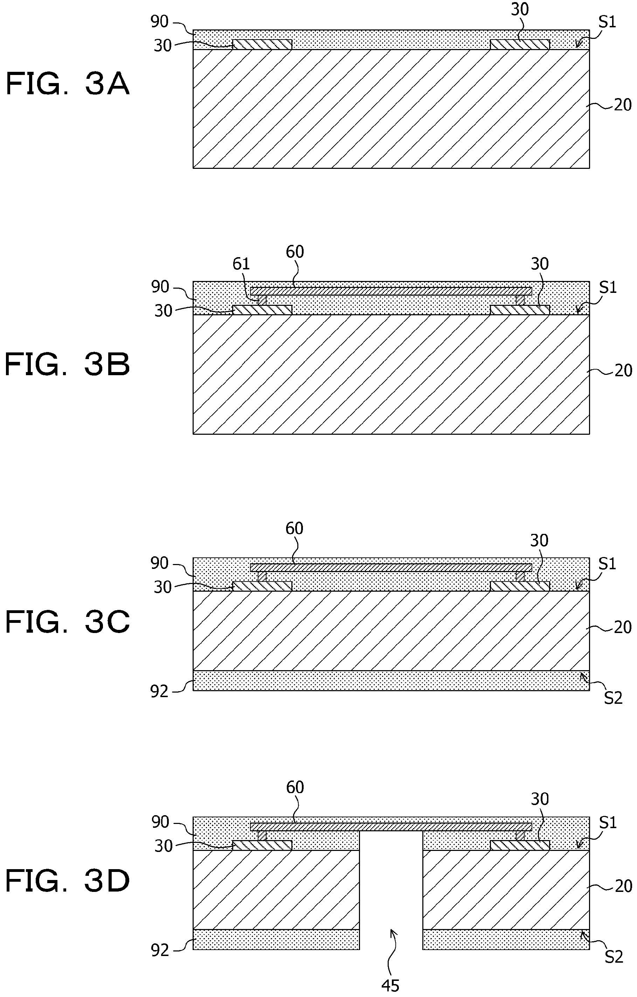

Hereinafter, a method of manufacturing the superconducting device 10 will be described. FIGs. 3A to 3M are cross-sectional views illustrating an example of the method of manufacturing the superconducting device 10.

First, the superconducting qubit elements 30 are formed on the surface S1 of the substrate 20 including a semiconductor such as Si, for example. Next, an insulator film including an insulator such as SiO₂ constituting the insulator layer 90 is formed on the surface S1 of the substrate 20 by, for example, a chemical vapor deposition (CVD) method. The superconducting qubit elements 30 are buried in the insulator layer 90 (FIG. 3A).

Next, after the vias 61 coupled to the superconducting qubit elements 30 are formed, a high melting point metal (for example, Ta) that exhibits superconductivity at a temperature equal to or lower than a predetermined temperature is deposited on a surface of the insulator layer 90 by, for example, a sputtering method. Thereafter, the wiring 60 is formed by patterning the high melting point metal. The wiring 60 is covered with the insulating film including the insulator such as SiO₂ constituting the insulator layer 90 (FIG. 3B). The via 61 includes the same high melting point metal (for example, Ta) as the wiring 60.

Next, the side of the surface S2 of the substrate 20 is ground to thin the substrate 20. Chemical mechanical polishing (CMP) and chemical liquid processing are performed as finishing of the thinning processing of the substrate 20. Next, the insulator layer 92 including an insulator such as SiO₂ is formed on the surface S2 of the substrate 20 by, for example, the CVD method (FIG. 3C).

Next, a through hole 45 penetrating the substrate 20 from the surface of the insulator layer 92 and reaching the wiring 60 is formed by, for example, reactive ion etching using a Bosch process. The Bosch process is a dry etching technology in which three steps of isotropic etching of the substrate 20, deposition of a protective film (not illustrated), and anisotropic etching of the substrate 20 (removal of a protective film on a bottom surface) are repeated to implement vertical deep digging of the substrate 20 at a high speed and a high aspect ratio. When the through hole 45 reaches the wiring 60, etching is stopped (FIG. 3D).

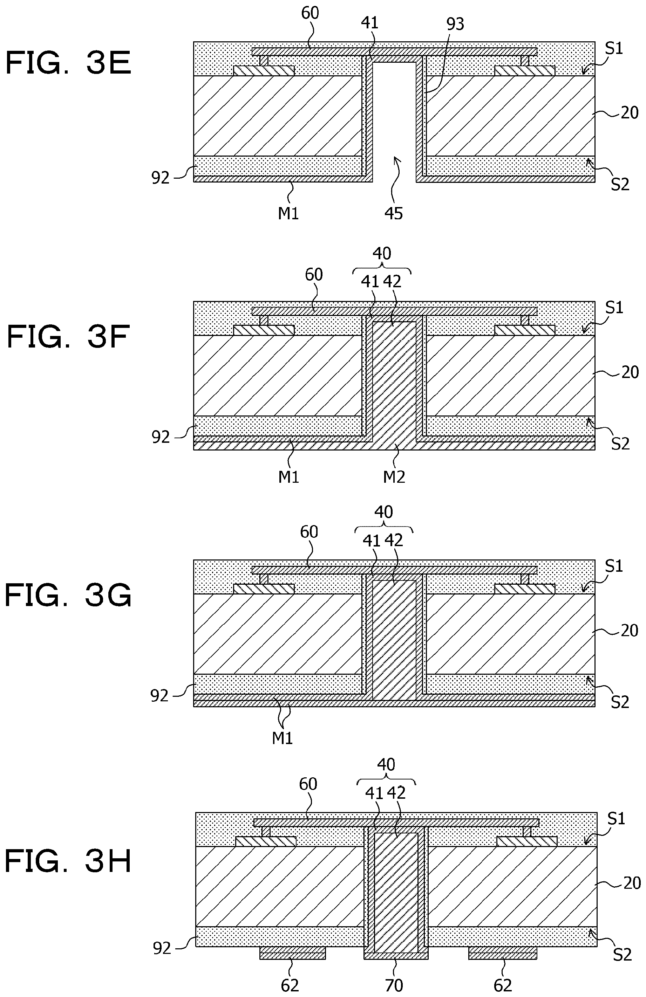

Next, the insulating film 93 including an insulator such as SiO₂ is formed on a side surface of the through hole 45 by, for example, the CVD method. Next, the same high melting point metal M1 (for example, Ta) as that of the wiring 60 is deposited on the side of the surface S2 of the substrate 20 by, for example, the sputtering method. The surface of the insulator layer 92, and the side surface and a bottom surface of the through hole 45 are covered with the high melting point metal M1. A portion covering the side surface and the bottom surface of the through hole 45 of the high melting point metal M1 becomes the outer portion 41 of the through electrode 40, and a portion covering the surface of the insulator layer 92 of the high melting point metal M1 becomes a part of the dummy wiring 62. The outer portion 41 of the through electrode 40 is coupled to the wiring 60 on the bottom surface of the through hole 45 (FIG. 3E).

Next, a seed layer (not illustrated) is formed on a surface of the high melting point metal M1 by, for example, the sputtering method, and then a low melting point metal M2 (for example, Sn) that exhibits superconductivity at a temperature equal to or lower than a predetermined temperature is deposited on the high melting point metal M1 by a plating method. The through hole 45 is filled with the low melting point metal M2, thereby forming the inner portion 42 of the through electrode 40 (FIG. 3F).

Next, the excessive low melting point metal M2 deposited on the insulator layer 92 is removed by, for example, the CMP. Thereafter, the same high melting point metal M1 (for example, Ta) as those of the wiring 60 and the outer portion 41 of the through electrode 40 is further deposited on the side of the surface S2 of the substrate 20 by, for example, the sputtering method (FIG. 3G).

Next, the high melting point metal M1 is patterned. With this configuration, the dummy wirings 62 are formed on the side of the surface S2 of the substrate 20, and the cap film 70 that closes the end portion of the through electrode 40 on the side of the surface S2 of the substrate 20 is formed (FIG. 3H).

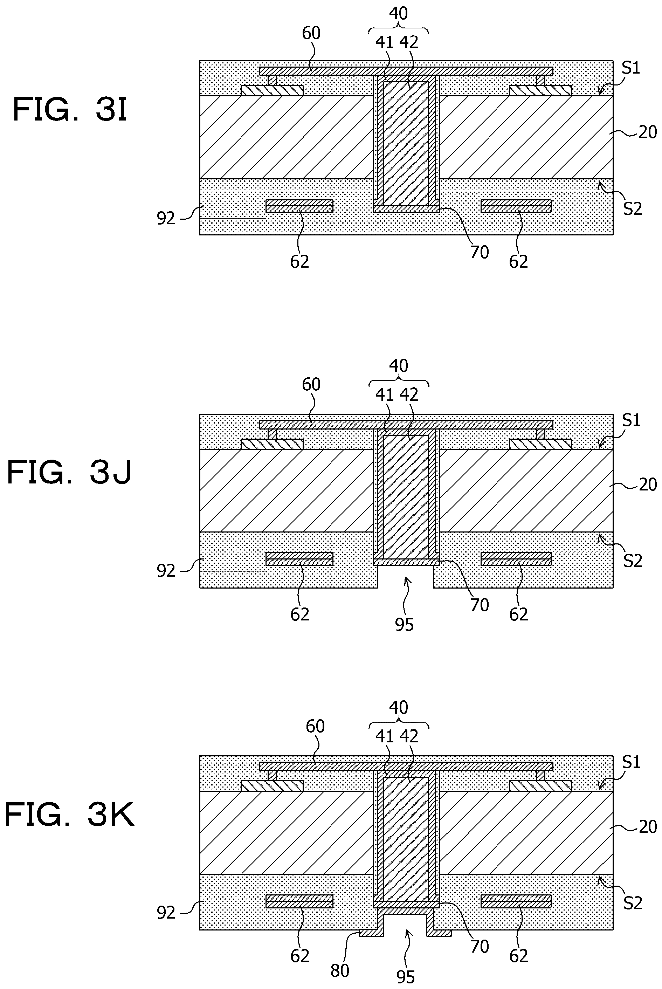

The dummy wirings 62 are covered with an insulating film including the insulator such as SiO₂ constituting the insulator layer 92 (FIG. 3I). Next, a contact hole 95 reaching the cap film 70 from the surface of the insulator layer 92 is formed by, for example, the reactive ion etching (FIG. 3J).

Next, the same high melting point metal (for example, Ta) as those of the wiring 60, the outer portion 41 of the through electrode 40, the cap film 70, and the dummy wirings 62 is deposited on the side of the surface S2 of the substrate 20 by, for example, the sputtering method, and the high melting point metal is patterned to form the base film 80. The base film 80 is coupled to the cap film 70 on a bottom surface of the contact hole 95 (FIG. 3K).

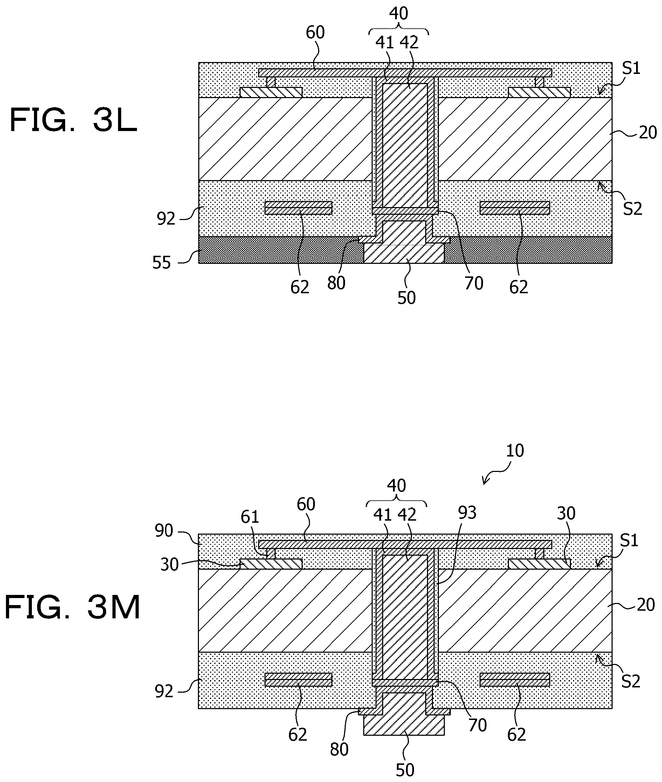

Next, a solder resist 55 is formed on the surface of the insulator layer 92. The solder resist 55 is provided with an opening through which the base film 80 is exposed. Next, the same low melting point metal (for example, Sn) as that of the inner portion 42 of the through electrode 40 is deposited on the base film 80 by the plating method. With this configuration, the junction electrode 50 is formed (FIG. 3L). Finally, the solder resist 55 is removed (FIG. 3M).

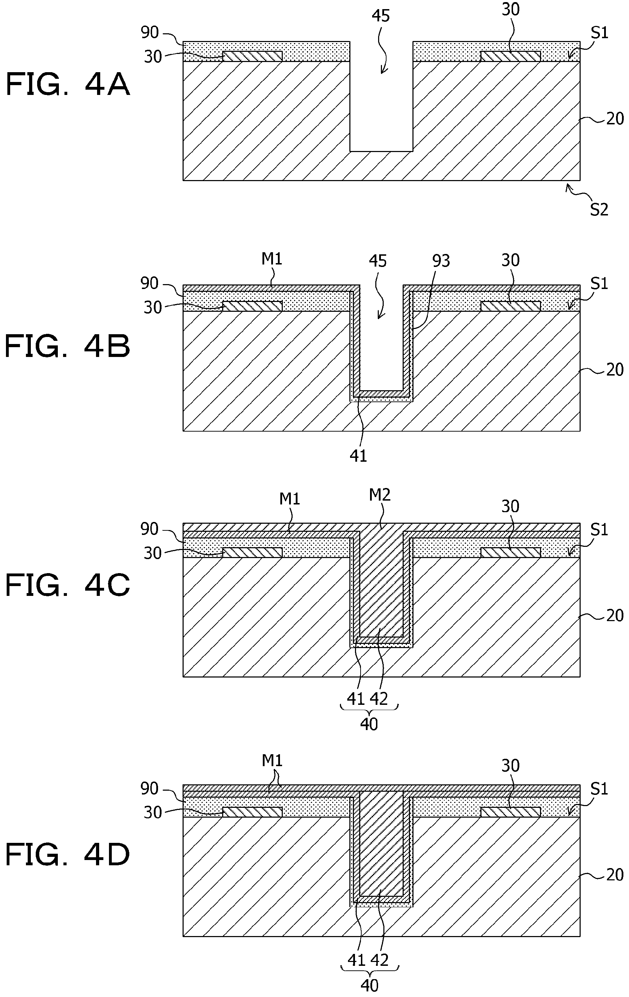

In the description above, the method of manufacturing in a case where the through hole 45 for forming the through electrode 40 is formed from the side of the surface S2 of the substrate 20 has been exemplified, but the through hole 45 may also be formed from the side of the surface S1 of the substrate 20. Hereinafter, a method of manufacturing in a case where the through hole 45 is formed from the side of the surface S1 of the substrate 20 will be described with reference to FIGs. 4A to 4K.

The through hole 45 is formed from the side of the surface S1 of the substrate 20 on which the superconducting qubit element 30 and the insulator layer 90 are formed by, for example, the reactive ion etching using the Bosch process. The etching is stopped before the through hole 45 reaches the surface S2 (FIG. 4A).

Next, the insulating film 93 including an insulator such as SiO₂ is formed on the side surface and the bottom surface of the through hole 45 by, for example, the CVD method. Next, the high melting point metal M1 (for example, Ta) that exhibits superconductivity at the temperature equal to or lower than the predetermined temperature is deposited on the side of the surface S1 of the substrate 20 by, for example, the sputtering method. The surface of the insulator layer 90, and the side surface and the bottom surface of the through hole 45 are covered with the high melting point metal M1. A portion covering the side surface and the bottom surface of the through hole 45 of the high melting point metal M1 becomes the outer portion 41 of the through electrode 40 (FIG. 4B).

Next, a seed layer (not illustrated) is formed on the surface of the high melting point metal M1 by, for example, the sputtering method, and then the low melting point metal M2 (for example, Sn) that exhibits superconductivity at the temperature equal to or lower than the predetermined temperature is deposited on the high melting point metal M1 by the plating method. The through hole 45 is filled with the low melting point metal M2, thereby forming the inner portion 42 of the through electrode 40 (FIG. 4C).

Next, the excessive low melting point metal M2 deposited on the insulator layer 90 is removed by, for example, the CMP. Thereafter, the same high melting point metal M1 (for example, Ta) as that of the outer portion 41 of the through electrode 40 is further deposited on the side of the surface S1 of the substrate 20 by, for example, the sputtering method (FIG. 4D).

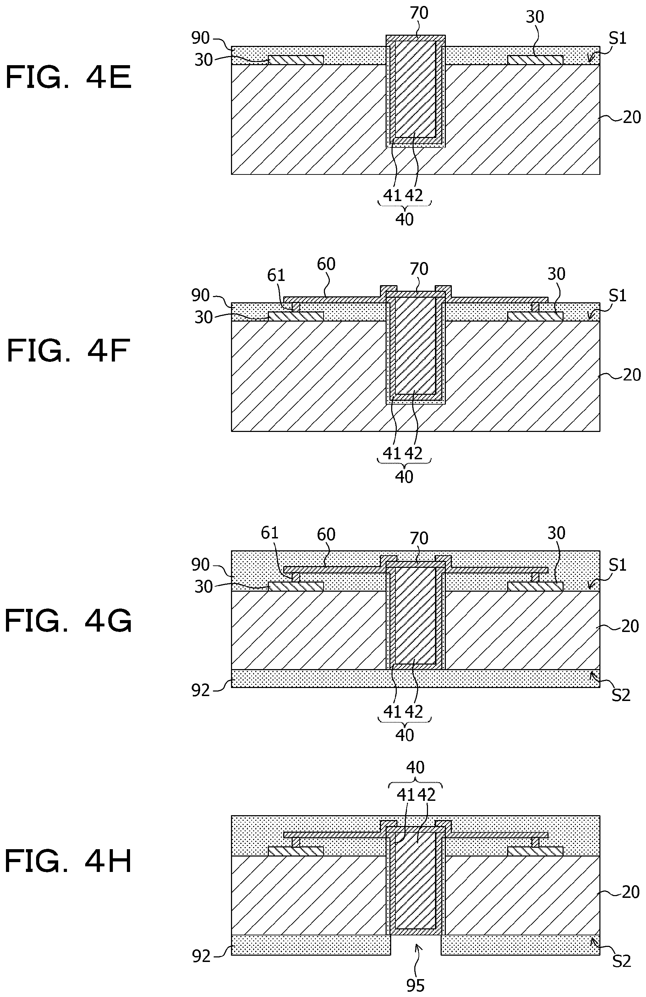

Next, the high melting point metal M1 is patterned. With this configuration, the cap film 70 that closes an end portion of the through electrode 40 on the side of the surface S1 of the substrate 20 is formed (FIG. 4E).

Next, after the vias 61 coupled to the superconducting qubit elements 30 are formed, the same high melting point metal (for example, Ta) as those of the outer portion 41 of the through electrode 40 and the cap film 70 is deposited on the side of the surface S1 of the substrate 20 by, for example, the sputtering method, and the high melting point metal is patterned. With this configuration, the wiring 60 electrically coupled to the superconducting qubit elements 30 and the through electrode 40 is formed (FIG. 4F).

The wiring 60 is covered with the insulating film including the insulator such as SiO₂ constituting the insulator layer 90. Next, the side of the surface S2 of the substrate 20 is ground to thin the substrate 20 until the through electrode 40 is exposed. The CMP and the chemical liquid processing are performed as finishing of the thinning processing of the substrate 20. Next, the insulator layer 92 including an insulator such as SiO₂ is formed on the surface S2 of the substrate 20 by, for example, the CVD method (FIG. 4G).

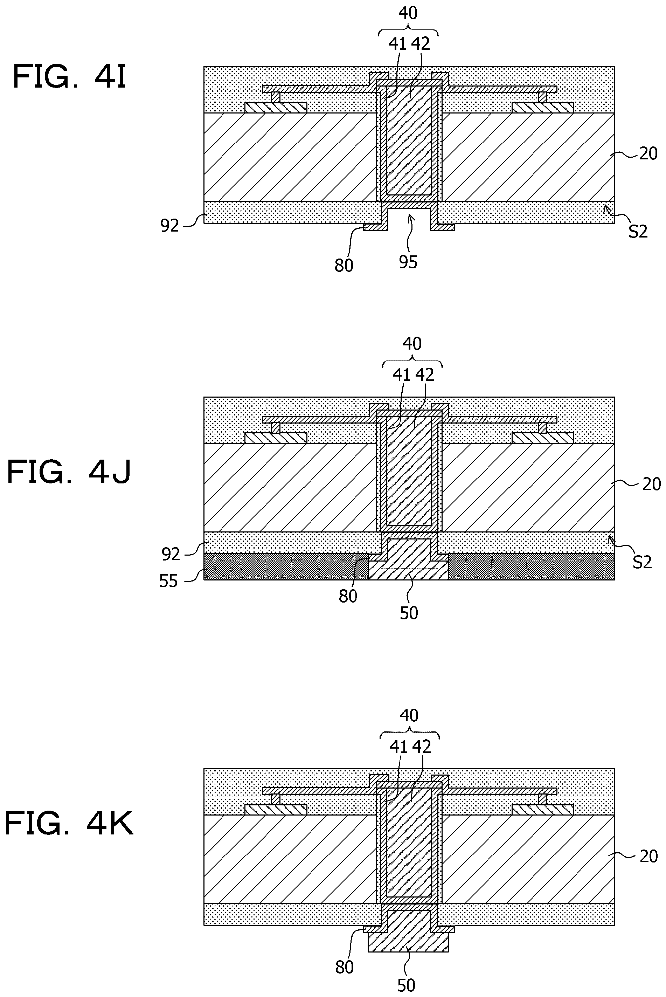

Next, the contact hole 95 reaching the through electrode 40 from the surface of the insulator layer 92 is formed by, for example, the reactive ion etching (FIG. 4H). Next, the same high melting point metal (for example, Ta) as those of the wiring 60, the outer portion 41 of the through electrode 40, and the cap film 70 is deposited on the side of the surface S2 of the substrate 20 by, for example, the sputtering method, and the high melting point metal is patterned to form the base film 80. The base film 80 is coupled to the through electrode 40 on the bottom surface of the contact hole 95 (FIG. 4I).

Next, the solder resist 55 is formed on the surface of the insulator layer 92. The solder resist 55 is provided with the opening through which the base film 80 is exposed. Next, the same low melting point metal (for example, Sn) as that of the inner portion 42 of the through electrode 40 is deposited on the base film 80 by the plating method. With this configuration, the junction electrode 50 is formed (FIG. 4J). Finally, the solder resist 55 is removed (FIG. 4K).

As described above, according to the superconducting device 10 according to the present embodiment, since the through electrode 40 penetrating the substrate 20 is included, it is possible to perform three-dimensional mounting in which the superconducting device 10 and another device are laminated. The superconducting device 10 is joined to another device via the junction electrode 50. In the joining between the superconducting device 10 and another device, the reflow processing for melting the junction electrode 50 is performed. Volumes of the junction electrode 50 and the through electrode 40 may fluctuate due to heating in the reflow processing. In the superconducting device 10 according to the present embodiment, the junction electrode 50 is disposed immediately below the through electrode 40, a volume of the structure in which the junction electrode 50 and the through electrode 40 are integrated tends to increase, and stress due to volume fluctuation becomes a problem. However, in the superconducting device 10 according to the present embodiment, the cap film 70 and the base film 80 including the high melting point metals function as the partition walls separating the through electrode 40 and the junction electrode 50. In general, the high melting point metal has a smaller thermal expansion coefficient than that of the low melting point metal, and thus the volume fluctuation in the through electrode 40 and the volume fluctuation in the junction electrode 50 may be divided by separating the through electrode 40 and the junction electrode 50 from each other by the partition walls formed of the high melting point metals. With this configuration, it is possible to suppress the stress associated with the volume fluctuation in the through electrode 40 and the junction electrode 50.

Furthermore, the low melting point metal constituting the inner portion 42 of the through electrode 40 is completely surrounded (sealed) by the high melting point metal constituting the outer portion of the through electrode 40 and the high melting point metal constituting the cap film 70. Since the volume fluctuation associated with temperature change of the inner portion 42 of the through electrode 40 is limited by the high melting point metals surrounding the inner portion 42 of the through electrode 40, the volume fluctuation associated with the temperature change of the through electrode 40 may be suppressed. Furthermore, although the low melting point metal constituting the inner portion 42 of the through electrode 40 may be melted in the reflow processing, the high melting point metal constituting the outer portion 41 of the through electrode 40 is not melted, so that diffusion of the melted low melting point metal constituting the inner portion 42 into the substrate 20 may be suppressed.

Furthermore, in the superconducting device 10 according to the present embodiment, all of the wiring 60, the outer portion 41 of the through electrode 40, the cap film 70, and the base film 80 include the same high melting point metal. With this configuration, alloy formation in a case where dissimilar metals are used is avoided. When an alloy is formed, a decoherence effect increases, and it may be difficult to maintain a quantum mechanical superposition state.

Note that, in the description above, a mode in which the inner portion 42 of the through electrode 40 includes the low melting point metal that exhibits superconductivity at the temperature equal to or lower than the predetermined temperature has been exemplified, but the present disclosure is not limited to this. For example, the inner portion 42 of the through electrode 40 may include the same kind of material as that of the substrate 20 or an oxide of the material constituting the substrate 20. In other words, the inside of the through electrode 40 may be filled with the same kind of material as that of the substrate 20 or the oxide of the material constituting the substrate 20. For example, in a case where the substrate 20 is a Si substrate, the inner portion 42 of the through electrode 40 may include polysilicon or SiO₂. The same kind of material as that of the substrate 20 or the oxide of the material constituting the substrate 20, which constitutes the inner portion 42 of the through electrode 40, is surrounded by the high melting point metal that exhibits superconductivity at the temperature equal to or lower than the predetermined temperature. Since the inner portion 42 of the through electrode 40 includes the same kind of material as that of the substrate 20 or the oxide of the material constituting the substrate 20, the volume fluctuation associated with the temperature change of the through electrode 40 and the substrate 20 occurs at substantially the same ratio (in other words, thermal expansion coefficients of the through electrode 40 and the substrate 20 are substantially the same), the stress associated with the temperature change may be suppressed.

Furthermore, the inner portion 42 of the through electrode 40 may include an insulator. Furthermore, the inner portion 42 of the through electrode 40 may include the same high melting point metal as that of the outer portion 41 of the through electrode 40. With this configuration, as compared with a case where the inner portion 42 of the through electrode 40 includes the low melting point metal, it is possible to suppress the volume fluctuation associated with the temperature change of the through electrode 40. Note that, since it is generally difficult to form a film of the high melting point metal by the plating method, the sputtering method or the CVD method is applied as a film formation method for charging the inside of the through electrode 40.

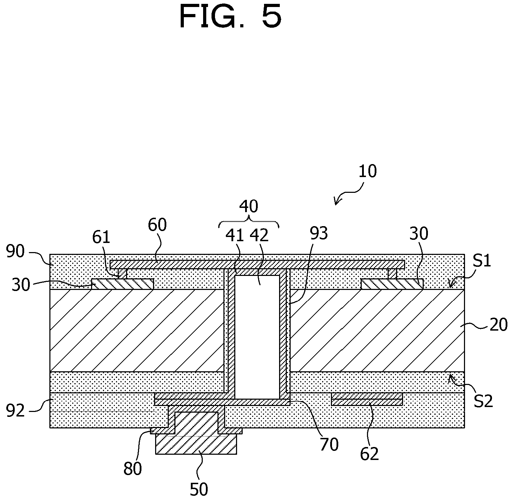

Furthermore, as illustrated in FIG. 5, the inner portion 42 of the through electrode 40 may be a cavity. With this configuration, as compared with a case where the inner portion 42 of the through electrode 40 includes the low melting point metal, it is possible to suppress the volume fluctuation associated with the temperature change of the through electrode 40. In the case where the inner portion 42 of the through electrode 40 is assumed to be the cavity, the junction electrode 50 is preferably provided at a position shifted from that of the through electrode 40 in a main surface direction of the substrate 20 from a viewpoint of securing mechanical strength. Note that, since the through electrode 40 exhibits superconductivity, electric resistance does not become a problem. Therefore, the through electrode 40 may include only a thin high melting point metal constituting the outer portion 41.

### [Second Embodiment]

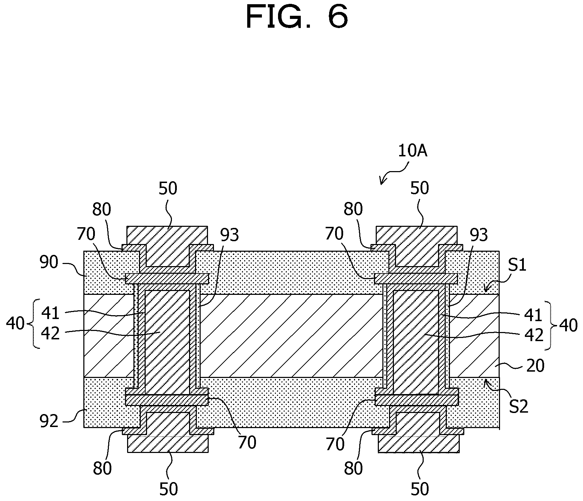

FIG. 6 is a cross-sectional view illustrating an example of a configuration of a superconducting device 10A according to a second embodiment of the disclosed technology. The superconducting device 10A according to the present embodiment has a form of an interposer that mediates signal transmission between devices, and is different from the superconducting device 10 according to the first embodiment in that a superconducting qubit element is not included. The superconducting device 10A includes a substrate 20, through electrodes 40, and junction electrodes 50.

The substrate 20 includes an insulator or a semiconductor. Use of a semiconductor such as silicon as the substrate 20 facilitates application of an existing semiconductor processing technology.

One end of the through electrode 40 is coupled to the junction electrode 50 via a cap film 70 provided on a side of a surface S1 of the substrate 20, and the other end is coupled to the junction electrode 50 via a cap film 70 provided on a side of a surface S2 of the substrate 20.

An outer portion 41 of the through electrode 40 includes a high melting point metal that exhibits superconductivity at a temperature equal to or lower than a predetermined temperature, and surrounds an inner portion 42. The inner portion 42 of the through electrode 40 includes a low melting point metal that exhibits superconductivity at a temperature equal to or lower than a predetermined temperature. Both ends of the through electrode 40 are closed by the cap films 70. The cap film 70 includes the same high melting point metal as that of the outer portion 41 of the through electrode 40. The cap film 70 functions as a partition wall separating the through electrode 40 and the junction electrode 50. The low melting point metal constituting the inner portion 42 of the through electrode 40 is completely surrounded (sealed) by the high melting point metal constituting the outer portion 41 of the through electrode 40 and the high melting point metal constituting the cap film 70.

The junction electrodes 50 are provided on both the side of the surface S1 and the side of the surface S2 of the substrate 20. The junction electrode 50 includes the same low melting point metal as that of the inner portion 42 of the through electrode 40. Base films 80 are interposed between the junction electrodes 50 and insulator layers 90 and 92. The base films 80 function as so-called under bump metals, and have a function of suppressing diffusion of the low melting point metals constituting the junction electrodes 50 into the insulator layers 90 and 92 and a function of enhancing adhesion between the junction electrodes 50 and the insulator layers 90 and 92. Furthermore, the base films 80 function as partition walls separating the through electrode 40 and the junction electrode 50. The base film 80 includes the same high melting point metal as those of the outer portions 41 of the through electrodes 40 and the cap films 70.

The junction electrodes 50 on the side of the surface S1 of the substrate 20 are joined to a first device (not illustrated), and the junction electrodes 50 on the side of the surface S2 of the substrate 20 are joined to a second device (not illustrated). The first device and the second device may perform signal transmission via the through electrodes 40. Note that, since various processes for manufacturing the superconducting device 10 according to the first embodiment may be applied to a method of manufacturing the superconducting device 10A according to the present embodiment, description thereof will be omitted.

According to the superconducting device 10A according to the present embodiment, similarly to the superconducting device 10 according to the first embodiment, since the through electrodes 40 and the junction electrodes 50 are divided by the partition walls, it is possible to suppress stress associated with temperature change.

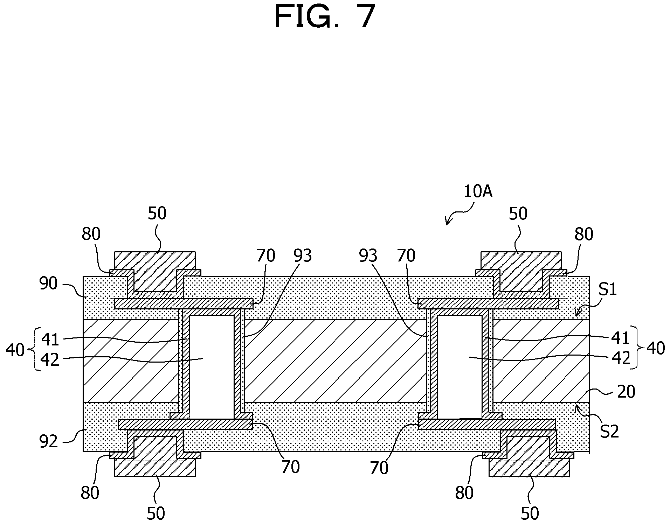

Note that the inner portion 42 of the through electrode 40 may include the same kind of material as that of the substrate 20 or an oxide of the material constituting the substrate 20. Furthermore, the inner portion 42 of the through electrode 40 may include an insulator. Furthermore, the inner portion 42 of the through electrode 40 may include the same high melting point metal as that of the outer portion 41 of the through electrode 40. Furthermore, as illustrated in FIG. 7, the inner portion 42 of the through electrode 40 may be a cavity. In the case where the inner portion 42 of the through electrode 40 is assumed to be the cavity, the junction electrode 50 is preferably provided at a position shifted from that of the through electrode 40 in a main surface direction of the substrate 20 from a viewpoint of securing mechanical strength.

### [Third Embodiment]

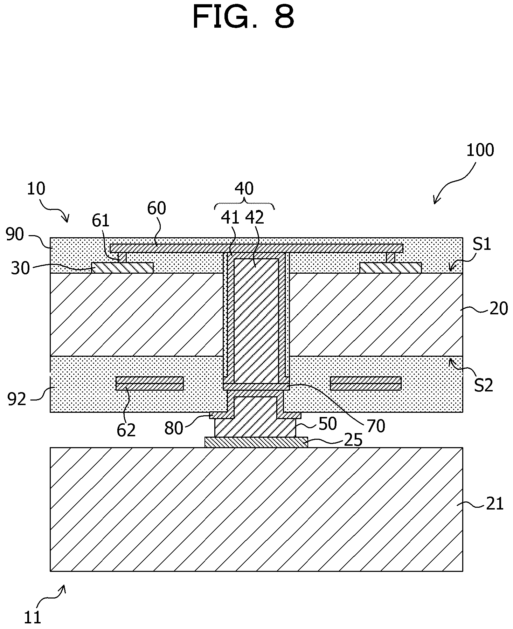

FIG. 8 is a cross-sectional view illustrating an example of a configuration of a laminated body 100 according to a third embodiment of the disclosed technology. The laminated body 100 is formed by laminating the superconducting device 10 according to the first embodiment described above and another device 11. The another device 11 may be, for example, a reading device having a function of reading a qubit output from the superconducting device 10. The junction electrode 50 of the superconducting device 10 is joined to a pad 25 provided on a surface of a substrate 21 of the another device 11.

In the joining between the superconducting device 10 and the another device 11, reflow processing for melting the junction electrode 50 is performed. In the superconducting device 10, the cap film 70 and the base film 80 including the high melting point metal function as the partition walls separating the through electrode 40 and the junction electrode 50, so that the volume fluctuation in the through electrode 40 and the volume fluctuation in the junction electrode 50 may be divided. With this configuration, it is possible to suppress the stress associated with the volume fluctuation in the through electrode 40 and the junction electrode 50.

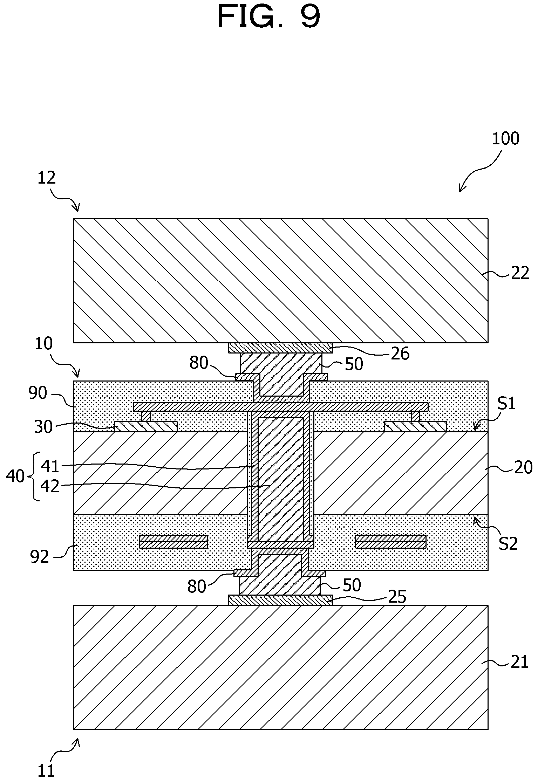

Note that, as illustrated in FIG. 9, in the superconducting device 10, the junction electrodes 50 may be provided on both the side of the surface S1 and the side of the surface S2 of the substrate 20, and another devices 11 and 12 may be laminated on both the side of the surface S1 and the side of the surface S2 of the substrate 20. The junction electrode 50 on the side of the surface S2 of the superconducting device 10 is joined to the pad 25 provided on the surface of the substrate 21 of the another device 11, and the junction electrode 50 on the side of the surface S1 of the superconducting device 10 is joined to a pad 26 provided on a surface of a substrate 22 of the another device 12.

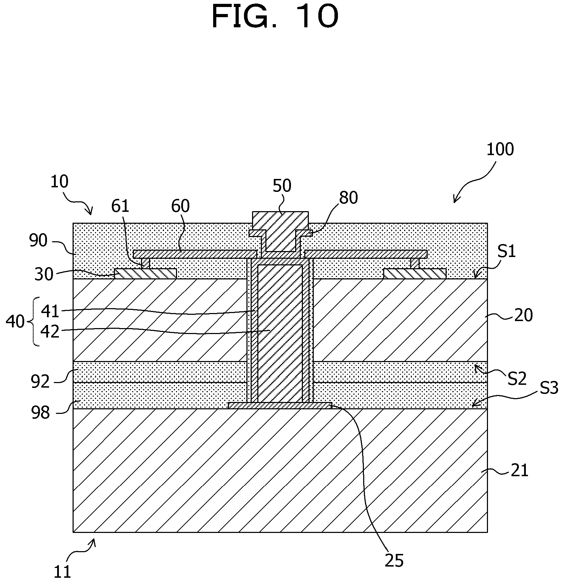

Furthermore, as illustrated in FIG. 10, the joining between the superconducting device 10 and the another device 11 may be normal temperature joining or joining with an adhesive instead of joining via the junction electrode 50. In the laminated body 100 illustrated in FIG. 10, the through electrode 40 is formed after the insulator layer 92 provided on the side of the surface S2 of the substrate 20 of the superconducting device 10 and an insulator layer 98 provided on a side of a surface S3 of the substrate 21 of the another device 11 are joined to each other by normal temperature joining or joined with an adhesive. The through electrode 40 is coupled to the pad 25 provided on the surface of the substrate 21 of the another device 11. The superconducting device 10 includes the junction electrode 50 provided on the side of the surface S1 of the substrate 20. Still another device (not illustrated) may be joined onto the superconducting device 10 via the junction electrode 50.

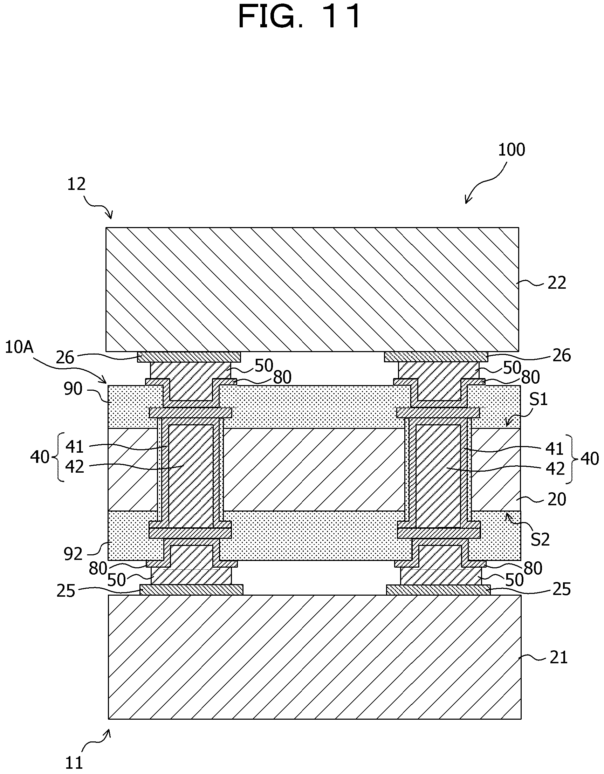

FIG. 11 is a cross-sectional view illustrating an example of a configuration of the laminated body including the superconducting device 10A according to the second embodiment described above and the another devices 11 and 12. The superconducting device 10A is an interposer that mediates signal transmission in the another devices 11 and 12. For example, the another device 12 may have a function of outputting a qubit, and the another device 11 may have a function of reading a qubit. The junction electrodes 50 on the side of the surface S2 of the superconducting device 10A are joined to the pads 25 provided on the surface of the substrate 21 of the another device 11, and the junction electrodes 50 on the side of the surface S1 of the superconducting device 10A are joined to the pads 26 provided on the surface of the substrate 22 of the another device 12.

### CITATION LIST

### PATENT DOCUMENT

Patent Document 1: Japanese National Publication of International Patent Application No. 2020-520090

### REFERENCE SIGNS LIST

- 10, 10A: Superconducting device
- 11, 12: Another device
- 20, 21, 22: Substrate
- 30: Superconducting qubit element
- 40: Through electrode
- 41: Outer portion
- 42: Inner portion
- 45: Through hole
- 50: Junction electrode
- 60: Wiring
- 61: Via
- 62: Dummy wiring
- 70: Cap film
- 80: Base film
- 90, 92: Insulator layer
- 100: Laminated body

## Claims

1. A superconducting device (10) comprising:
a substrate (20);
a through hole (45) provided in the substrate (20);
a through electrode (40) that is an electrode provided in the through hole (45) and that includes a first portion (42) and a second portion (41) provided between the first portion (42) and an inner wall surface of the through hole (45), in which the second portion (41) is formed of a material that includes a first metal that exhibits superconductivity at a temperature equal to or lower than a predetermined temperature;
a junction electrode (50) that is an electrode electrically coupled to the through electrode (40) via a partition wall (70, 80), that has at least a part provided outside the through hole (45) and is provided on a side of a surface (S2) of the substrate (20) below the through electrode (40), and that is formed of a material that includes a second metal that exhibits superconductivity at a temperature equal to or lower than a predetermined temperature; and
the partition wall (80) being provided between the through electrode (40) and the junction electrode (50) and being formed of a material that includes the first metal,
wherein:
a melting point of the first metal is higher than a melting point of the second metal; the second portion (41) and the partition wall (80) surround the first portion (42);
**characterized in that** the first portion (42) is formed of a material that includes the second metal or the first portion (42) is formed of the same kind of material as a material of the substrate or a material that includes an oxide of the material that constitutes the substrate (20).

2. The superconducting device (10) according to claim 1, further comprising:
a superconducting qubit element provided on the substrate (20); and
a wiring that is electrically coupled to the superconducting qubit element and the through electrode (40) and that is formed of a material that includes the first metal.

3. The superconducting device (10) according to claim 2, further comprising
a dummy wiring that is provided on a side of a surface of the substrate (20) opposite to a surface of a side on which the wiring is provided and that is not coupled to the superconducting qubit element.

4. The superconducting device (10) according to any one of claims 1 to 3, wherein
the junction electrode (50) has a portion provided in an insulator layer, and
a base film formed of a material that includes the first metal is further included between the junction electrode (50) and the insulator layer.

5. A method of manufacturing a superconducting device (10), comprising processing of:
forming, in a substrate (20), a hole (45) that penetrates the substrate (20);
forming, in the hole (45), a through electrode (40) that includes a first portion (42) disposed in the hole (45) and a second portion (41) provided between the first portion (42) and an inner wall surface of the hole (45), in which the second portion (41) is formed of a material that includes a first metal that exhibits superconductivity at a temperature equal to or lower than a predetermined temperature;
forming a partition wall (70, 80) that includes the first metal on a bottom surface of the through electrode (40); and
forming a junction electrode (50) that is in contact with the partition wall (80), the junction electrode (50) having at least a part provided outside the hole (45) and being provided on a side of a surface (S2) of the substrate (20) below the through electrode (40), the junction electrode (50) being electrically coupled to the through electrode (40), and being formed of a material that includes a second metal that exhibits superconductivity at a temperature equal to or lower than a predetermined temperature,
wherein:
a melting point of the first metal is higher than a melting point of the second metal; and
**characterized in that** the forming of the through electrode (40) includes:
forming the first portion (42) by filling a material that includes the second metal inside the hole (45) in which the second portion (41) is formed and forming the first portion (42); or
forming the first portion (42) by filling the same material as a material of the substrate (20) or a material that includes an oxide of the material inside the hole (45) in which the second portion (41) is formed, and forming the first portion (42).

6. The method of manufacturing according to claim 5, further comprising:
forming a wiring that electrically couples a superconducting qubit element provided on the substrate (20) and the through electrode (40) and that is formed of a material that includes the first metal.

7. The method of manufacturing according to claim 5 or 6, wherein
the forming of the through electrode (40) includes:
covering an inner wall surface and a bottom surface of the hole (45) with a material that includes the first metal via an insulating film (93).

8. The method of manufacturing according to claim 7, wherein
the forming of the partition wall (80) includes:
covering an end portion of the hole (45) with a material that includes the first metal so as to close inside of the hole (45) before the junction electrode (50) is formed.

9. The method of manufacturing according to any one of claims 5 to 8, wherein
the forming of the junction electrode (50) includes:
forming an opening that reaches the partition wall in an insulator layer provided on a surface of the substrate (20);
forming a base film that includes the first metal on a surface of the opening of the insulator layer; and
depositing a material that includes the second metal on the base film.

10. A laminated body (100) in which the superconducting device (10) of any one of claims 1-4, and another device (11) are laminated.

11. The laminated body (100) according to claim 10, wherein the junction electrode (50) is coupled to the another device (11).

## Patentansprüche

1. Supraleitende Vorrichtung (10), umfassend:
ein Substrat (20);
ein Durchgangsloch (45), das im Substrat (20) bereitgestellt ist;
eine Durchgangselektrode (40), bei der es sich um eine Elektrode handelt, die im Durchgangsloch (45) bereitgestellt ist und die einen ersten Abschnitt (42) und einen zweiten Abschnitt (41) einschließt, der zwischen dem ersten Abschnitt (42) und einer inneren Wandfläche des Durchgangslochs (45) bereitgestellt ist, wobei der zweite Abschnitt (41) aus einem Material gebildet ist, das ein erstes Metall einschließt, das bei einer Temperatur gleich oder kleiner als eine vorbestimmte Temperatur Supraleitfähigkeit zeigt;
eine Verbindungselektrode (50), bei der es sich um eine Elektrode handelt, die über eine Teilungswand (70, 80) mit der Durchgangselektrode (40) gekoppelt ist, die mindestens einen Teil aufweist, der außerhalb des Durchgangslochs (45) bereitgestellt ist und an einer Seite einer Fläche (S2) des Substrats (20) unterhalb der Durchgangselektrode (40) bereitgestellt ist und die aus einem Material gebildet ist, das ein zweites Metall einschließt, das bei einer Temperatur gleich oder kleiner als eine vorbestimmte Temperatur Supraleitfähigkeit zeigt; und
wobei die Teilungswand (80) zwischen der Durchgangselektrode (40) und der Verbindungselektrode (50) bereitgestellt ist und aus einem Material gebildet ist, das das erste Metall einschließt,
wobei:
ein Schmelzpunkt des ersten Metalls höher ist als ein Schmelzpunkt des zweiten Metalls; der zweite Abschnitt (41) und die Teilungswand (80) den ersten Abschnitt (42) umgeben;
**dadurch gekennzeichnet, dass** der erste Abschnitt (42) aus einem Material gebildet ist, das das zweite Metall einschließt, oder der erste Abschnitt (42) aus der gleichen Art von Material wie ein Material des Substrats oder einem Material gebildet ist, das ein Oxid des Materials einschließt, das das Substrat (20) konstituiert.

2. Supraleitende Vorrichtung (10) nach Anspruch 1, weiter umfassend:
ein supraleitendes Qubit-Element, das auf dem Substrat (20) bereitgestellt ist; und
eine Verdrahtung, die elektrisch mit dem supraleitenden Qubit-Element und der Durchgangselektrode (40) gekoppelt ist und die aus einem Material gebildet ist, das das erste Metall einschließt.

3. Supraleitende Vorrichtung (10) nach Anspruch 2, weiter umfassend
eine Dummy-Verdrahtung, die auf einer Seite einer Fläche des Substrats (20) gegenüber einer Fläche einer Seite bereitgestellt ist, auf der die Verdrahtung bereitgestellt ist und die nicht mit dem supraleitenden Qubit-Element gekoppelt ist.

4. Supraleitende Vorrichtung (10) nach einem der Ansprüche 1 bis 3, wobei
die Verbindungselektrode (50) einen Abschnitt aufweist, der in einer Isolationsschicht bereitgestellt ist, und
ein Basisfilm, der aus einem Material gebildet ist, das das erste Metall einschließt, weiter zwischen der Verbindungselektrode (50) und der Isolationsschicht eingeschlossen ist.

5. Verfahren zum Herstellen einer supraleitenden Vorrichtung (10), umfassend Verarbeiten von Folgendem:
Bilden, in einem Substrat (20), eines Lochs (45), das das Substrat (20) durchdringt;
Bilden, im Loch (45), einer Durchgangselektrode (40), die einen ersten Abschnitt (42), der im Loch (45) angeordnet ist, und einen zweiten Abschnitt (41) einschließt, der zwischen dem ersten Abschnitt (42) und einer inneren Wandfläche des Lochs (45) bereitgestellt ist, wobei der zweite Abschnitt (41) aus einem Material gebildet ist, das ein erstes Metall einschließt, das bei einer Temperatur gleich oder kleiner als eine vorbestimmte Temperatur Supraleitfähigkeit zeigt;
Bilden einer Teilungswand (70, 80), die das erste Metall einschließt, auf einer Bodenfläche der Durchgangselektrode (40); und
Bilden einer Verbindungselektrode (50), die die Teilungswand (80) kontaktiert, wobei die Verbindungselektrode (50) mindestens einen Teil aufweist, der außerhalb des Lochs (45) bereitgestellt ist und auf einer Seite einer Fläche (S2) des Substrats (20) unterhalb der Durchgangselektrode (40) bereitgestellt ist, wobei die Verbindungselektrode (50) elektrisch mit der Durchgangselektrode (40) gekoppelt ist und aus einem Material gebildet ist, das ein zweites Metall einschließt, das bei einer Temperatur gleich oder kleiner als eine vorbestimmte Temperatur Supraleitfähigkeit zeigt,
wobei:
ein Schmelzpunkt des ersten Metalls höher ist als ein Schmelzpunkt des zweiten Metalls; und
**dadurch gekennzeichnet, dass** das Bilden der Durchgangselektrode (40) Folgendes einschließt:
Bilden des ersten Abschnitts (42) durch Füllen eines Materials, das das zweite Metall einschließt, innerhalb des Lochs (45), in dem der zweite Abschnitt (41) gebildet ist, und Bilden des ersten Abschnitts (42); oder
Bilden des ersten Abschnitts (42) durch Füllen des gleichen Materials wie ein Material des Substrats (20) oder eines Materials, das ein Oxid des Materials einschließt, innerhalb des Lochs (45), in dem der zweite Abschnitt (41) gebildet ist, und Bilden des ersten Abschnitts (42).

6. Herstellungsverfahren nach Anspruch 5, weiter umfassend:
Bilden einer Verdrahtung, die elektrisch mit einem supraleitenden Qubit-Element gekoppelt ist, das auf dem Substrat (20) und der Durchgangselektrode (40) bereitgestellt ist und das aus einem Material gebildet ist, das das erste Metall einschließt.

7. Herstellungsverfahren nach Anspruch 5 oder 6, wobei
das Bilden der Durchgangselektrode (40) Folgendes einschließt:
Bedecken einer inneren Wandfläche und einer Bodenfläche des Lochs (45) mit einem Material, das das erste Metall einschließt, über einen Isolierfilm (93).

8. Herstellungsverfahren nach Anspruch 7, wobei
das Bilden der Teilungswand (80) Folgendes einschließt:
Bedecken eines Endabschnitts des Lochs (45) mit einem Material, das das erste Metall einschließt, derart, dass das Innere des Lochs (45) verschlossen wird, bevor die Verbindungselektrode (50) gebildet wird.

9. Herstellungsverfahren nach einem der Ansprüche 5 bis 8, wobei
das Bilden der Verbindungselektrode (50) Folgendes einschließt:
Bilden einer Öffnung, die die Teilungswand erreicht, in einer Isolationsschicht, die auf einer Fläche des Substrats (20) bereitgestellt ist;
Bilden eines Basisfilms, der das erste Metall einschließt, auf einer Fläche der Öffnung der Isolationsschicht; und
Ablagern eines Materials, das das zweite Metall einschließt, auf dem Basisfilm.

10. Laminierter Körper (100), in dem die supraleitende Vorrichtung (10) nach einem der Ansprüche 1-4 und eine andere Vorrichtung (11) laminiert sind.

11. Laminierter Körper (100) nach Anspruch 10, wobei die Verbindungselektrode (50) mit der anderen Vorrichtung (11) gekoppelt ist.

## Revendications

1. Dispositif supraconducteur (10) comprenant :
un substrat (20) ;
un trou traversant (45) ménagé dans le substrat (20) ;
une électrode traversante (40) qui est une électrode disposée dans le trou traversant (45) et qui inclut une première partie (42) et une deuxième partie (41) disposée entre la première partie (42) et une surface de paroi interne du trou traversant (45), dans laquelle la deuxième partie (41) est formée d'un matériau qui inclut un premier métal qui présente une supraconductivité à une température inférieure ou égale à une température prédéterminée ;
une électrode (50) de jonction qui est une électrode couplée électriquement à l'électrode traversante (40) par le biais d'une paroi (70, 80) formant cloison, qui présente au moins une partie située à l'extérieur du trou traversant (45) et est disposée sur un côté d'une surface (S2) du substrat (20) sous l'électrode traversante (40), et qui est formée d'un matériau qui inclut un deuxième métal qui présente une supraconductivité à une température inférieure ou égale à une température prédéterminée ; et
la paroi (80) formant cloison étant disposée entre l'électrode traversante (40) et l'électrode (50) de jonction et étant formée d'un matériau qui inclut le premier métal,
dans lequel :
un point de fusion du premier métal est plus élevé qu'un point de fusion du deuxième métal ; la deuxième partie (41) et la paroi (80) formant cloison entourent la première partie (42) ;
**caractérisé en ce que** la première partie (42) est formée d'un matériau qui inclut le deuxième métal ou la première partie (42) est formée du même type de matériau qu'un matériau du substrat ou d'un matériau qui inclut un oxyde du matériau qui constitue le substrat (20).

2. Dispositif supraconducteur (10) selon la revendication 1, comprenant en outre :
un élément qubit supraconducteur disposé sur le substrat (20) ; et
un câblage qui est couplé électriquement à l'élément qubit supraconducteur et à l'électrode traversante (40) et qui est formé d'un matériau qui inclut le premier métal.

3. Dispositif supraconducteur (10) selon la revendication 2, comprenant en outre
un câblage factice qui est disposé sur un côté d'une surface du substrat (20) opposée à une surface d'un côté sur lequel le câblage est disposé et qui n'est pas couplé à l'élément qubit supraconducteur.

4. Dispositif supraconducteur (10) selon l'une quelconque des revendications 1 à 3, dans lequel
l'électrode (50) de jonction présente une partie disposée dans une couche isolante, et
un film de base formé d'un matériau qui inclut le premier métal est en outre inclus entre l'électrode (50) de jonction et la couche isolante.

5. Procédé de fabrication d'un dispositif supraconducteur (10), comprenant le traitement consistant à :
former, dans un substrat (20), un trou (45) qui pénètre dans le substrat (20) ;
former, dans le trou (45), une électrode traversante (40) qui inclut une première partie (42) disposée dans le trou (45) et une deuxième partie (41) disposée entre la première partie (42) et une surface de paroi interne du trou (45), dans laquelle la deuxième partie (41) est formée d'un matériau qui inclut un premier métal qui présente une supraconductivité à une température inférieure ou égale à une température prédéterminée ;
former une paroi (70, 80) formant cloison qui inclut le premier métal sur une surface inférieure de l'électrode traversante (40) ; et
former une électrode (50) de jonction qui est en contact avec la paroi (80) formant cloison, l'électrode (50) de jonction ayant au moins une partie disposée à l'extérieur du trou (45) et étant disposée sur un côté d'une surface (S2) du substrat (20) sous l'électrode traversante (40), l'électrode (50) de jonction étant couplée électriquement à l'électrode traversante (40), et étant formée d'un matériau qui inclut un deuxième métal qui présente une supraconductivité à une température inférieure ou égale à une température prédéterminée,
dans lequel :
un point de fusion du premier métal est plus élevé qu'un point de fusion du deuxième métal ; et
**caractérisé en ce que** la formation de l'électrode traversante (40) inclut :
la formation de la première partie (42) par remplissage d'un matériau qui inclut le deuxième métal à l'intérieur du trou (45) dans lequel la deuxième partie (41) est formée et la formation de la première partie (42) ; ou
la formation de la première partie (42) par remplissage du même matériau qu'un matériau du substrat (20) ou d'un matériau qui inclut un oxyde du matériau à l'intérieur du trou (45) dans lequel la deuxième partie (41) est formée, et la formation de la première partie (42).

6. Procédé de fabrication selon la revendication 5, comprenant en outre :
la formation d'un câblage qui couple électriquement un élément qubit supraconducteur disposé sur le substrat (20) et l'électrode traversante (40) et qui est formé d'un matériau qui inclut le premier métal.

7. Procédé de fabrication selon la revendication 5 ou la revendication 6, dans lequel
la formation de l'électrode traversante (40) inclut :
le recouvrement d'une surface de paroi interne et d'une surface inférieure du trou (45) par un matériau qui inclut le premier métal par le biais d'un film isolant (93).

8. Procédé de fabrication selon la revendication 7, dans lequel
la formation de la paroi (80) formant cloison inclut :
le recouvrement d'une partie d'extrémité du trou (45) par un matériau qui inclut le premier métal de façon à fermer l'intérieur du trou (45) avant que l'électrode (50) de jonction ne soit formée.

9. Procédé de fabrication selon l'une quelconque des revendications 5 à 8, dans lequel
la formation de l'électrode (50) de jonction inclut :
la formation d'une ouverture qui atteint la paroi formant cloison dans une couche isolante disposée sur une surface du substrat (20) ;
la formation d'un film de base qui inclut le premier métal sur une surface de l'ouverture de la couche isolante ; et
le dépôt d'un matériau qui inclut le deuxième métal sur le film de base.

10. Corps stratifié (100) dans lequel le dispositif supraconducteur (10) selon l'une quelconque des revendications 1 à 4 et un autre dispositif (11) sont stratifiés.

11. Corps stratifié (100) selon la revendication 10, dans lequel l'électrode (50) de jonction est couplée à l'autre dispositif (11).
